# EUROPÄISCHE PATENTANMELDUNG

(11) **EP 3 211 666 A1**
(43) Veröffentlichungstag der Anmeldung: **30.08.2017**
(21) Anmeldenummer: 16157519.6
(22) Anmeldetag: 26.02.2016
(51) Int. Cl.: H01L 23/15, H01L 21/48

(54) **MEHRFACHSUBSTRAT**

(71) Anmelder: Infineon Technologies AG, 85579 Neubiberg (DE)
(72) Erfinder: ROTH, Alexander, 93197 Zeitlarn (DE)
(74) Vertreter: Lohmanns, Bernard

(57) **Zusammenfassung**

Die Erfindung betrifft ein Mehrfachsubstrat mit einer Keramikplatte oder Keramikschicht (21), die wenigstens zwei aneinander anschließende und einstückig miteinander verbundene Einzelsubstrate (22, 31, 36, 46, 47) bildet, die durch wenigstens eine zwischen den Einzelsubstraten (22, 31, 36, 46, 47) verlaufende Schnittlinie (32, 37, 41, 42, 48, 49) voneinander abgegrenzt sind, wobei sich ein erster Rand (24) der Keramikschicht (21) entlang einer ersten Erstreckungsrichtung (25) erstreckt und sich ein zweiter Rand (26) der Keramikschicht (21) entlang einer zweiten Erstreckungsrichtung (27) erstreckt und wenigstens eine längste Ausdehnung des ersten Einzelsubstrats (22) entlang einer der beiden Erstreckungsrichtungen (25, 27) von einer längsten Ausdehnung des zweiten Einzelsubstrats (31, 36, 46, 47) entlang derselben Erstreckungsrichtung (25, 27) verschieden ist.

## Beschreibung

Die vorliegende Erfindung betrifft ein Mehrfachsubstrat nach dem Oberbegriff des Anspruchs 1.

Bekannt ist es, Substrate, insbesondere auch solche mit einer Isolier- oder Trägerschicht aus Keramik, beispielsweise Aluminium-Oxid-Keramik, im Mehrfachnutzen, das heißt als Mehrfachsubstrat mit einer Vielzahl von Einzelsubstraten auf der gemeinsamen Isolier- und Trägerschicht herzustellen und auch mit elektronischen Bauelementen zu bestücken, wobei das Mehrfachsubstrat dann für die weitere Verwendung in die Einzelsubstrate zertrennt bzw. vereinzelt wird. Dieses Vereinzeln erfolgt insbesondere bei Mehrfachsubstraten mit einer Isolier- und Trägerschicht aus Keramik durch Schneiden, insbesondere mittels Laser, entlang von die Einzelsubstrate begrenzende Schnittlinien und/oder durch Brechen entlang der Schnitt- bzw. Sollbruchlinien.

Derartige Mehrfachsubstrate sind beispielsweise in der DE 195 04 378 A1, der DE 44 44 680 A1 und der DE 93 10 299 U1 beschrieben.

Die vorstehend genannten Keramiksubstrate werden zum Herstellen von elektrischen Schaltkreisen, insbesondere Leistungsschaltkreisen, verwendet und sind gewöhnlich an wenigstens einer Oberflächenseite mit einer Metallisierung versehen, die unter Anwendung einer Ätztechnik derart strukturiert wird, dass sie die für den Schaltkreis erforderlichen Leiterbahnen, Kontaktflächen und dergleichen bildet.

Für eine rationelle Fertigung der elektrischen Schaltkreise ist es bekannt, die Herstellung dieser Schaltkreise im Mehrfachnutzen vorzunehmen, das heißt insbesondere die Strukturierung der Metallflächen zur Erzielung der notwendigen Leiterbahnen, Kontaktflächen und dergleichen, aber auch die Bestückung mit den elektronischen Bauelementen an dem Mehrfachnutzen vorzunehmen, der dann nach der Fertigstellung der Strukturierung bzw. Bestückung in die jeweiligen Einzelsubstrate getrennt wird.

Bekannte Mehrfachsubstrate weisen gewöhnlich eine rechteckige, flächige Form auf, auf der matrizen- oder schachbrettartig mehrere, in ihren Außenabmessungen gleichartig ausgebildete und gleichorientierte Einzelsubstrate angeordnet sind. In dem allgemeinen Fall, in dem die Abmessung des Mehrfachsubstrats in Längs- und Breitenrichtung nicht genau einem ganzzahligen Vielfachen der jeweiligen Längs- bzw. Breitenabmessung eines Einzelsubstrats entspricht, kann nicht die gesamte Fläche des Mehrfachsubstrats zur Anordnung der Einzelsubstrate genutzt werden. Es gibt somit einen Substratbereich des Mehrfachsubstrats, der nicht zur Fertigung der Einzelsubstrate genutzt werden kann und dementsprechend bei der Fertigung verloren geht.

Vor diesem Hintergrund liegt der vorliegenden Erfindung die Aufgabe zugrunde, ein Mehrfachsubstrat aufzuzeigen, das den vorgenannten Nachteil vermeidet und eine bessere, optimalere Nutzung der durch das Mehrfachsubstrat zur Verfügung gestellten Substratfläche ermöglicht.

Diese Aufgabe wird durch ein Mehrfachsubstrat mit den Merkmalen des Anspruchs 1 gelöst. Weitere, besonders vorteilhafte Ausgestaltungen der Erfindung offenbaren die Unteransprüche.

Es ist darauf hinzuweisen, dass die in der nachfolgenden Beschreibung einzeln aufgeführten Merkmale in beliebiger, technisch sinnvoller Weise miteinander kombiniert werden können und weitere Ausgestaltungen der Erfindung aufzeigen. Die Beschreibung charakterisiert und spezifiziert die Erfindung insbesondere im Zusammenhang mit den Figuren zusätzlich.

Es ist ferner darauf hinzuweisen, dass die nachfolgend beschriebene Erfindung auf jede Art von Substrat angewendet werden kann, zum Beispiel AlN (Aluminiumnitrid), Si₃N₄ (Siliziumnitrid), Al₂O₃ (Aluminiumoxid) und dergleichen. Ferner können die Substrate mit einer Metallisierung, zum Beispiel Cu (Kupfer) oder Al (Aluminium), beschichtet sein. Hierbei kann die Metallisierung durch unterschiedliche Verfahren auf wenigstens eine Oberflächenseite des Substrats aufgebracht sein, zum Beispiel durch AMB (Active Metal Brazing), DCB (Direct Copper Bonding), DAB (Direct Aluminum Bonding), Dickschichtverfahren und dergleichen. Besonders bevorzugt werden hierbei DCB- und AMB-KeramikSubstrate. Hierin nachstehend wird der Begriff "Substrat" als Synonym für alle zuvor genannten Substratarten verwendet.

Erfindungsgemäß weist ein Mehrfachsubstrat eine Keramikplatte oder eine Keramikschicht auf, die wenigstens zwei aneinander anschließende und einstückig miteinander verbundene Einzelsubstrate bildet. Die wenigstens zwei Einzelsubstrate sind durch wenigstens eine zwischen den Einzelsubstraten verlaufende Schnittlinie voneinander abgegrenzt. Als Schnittlinie ist hierbei eine solche Linie zu verstehen, entlang welcher das Mehrfachsubstrat in einem späteren Vereinzelungsschritt geschnitten und/oder gebrochen wird, um die Einzelsubstrate voneinander zu trennen.

Ein erster Rand der Keramikschicht erstreckt sich entlang einer ersten Erstreckungsrichtung und ein zweiter Rand der Keramikschicht erstreckt sich entlang einer zweiten Erstreckungsrichtung. In dem Fall eines rechteckigen Mehrfachsubstrats verlaufen die beiden Erstreckungsrichtungen senkrecht zueinander. Bevorzugt werden erfindungsgemäß rechteckige Mehrfachsubstrate, es ist jedoch zu verstehen, dass die Erfindung ebenso auf Mehrfachsubstrate mit anderen Grundformen angewendet werden kann.

Gemäß der Erfindung ist wenigstens eine längste Ausdehnung des ersten Einzelsubstrats entlang einer der beiden Erstreckungsrichtungen von einer längsten Ausdehnung des zweiten Einzelsubstrats entlang derselben Erstreckungsrichtung verschieden.

Dies bedeutet zum Beispiel, dass bei einer quadratischen oder kreisrunden Form des ersten Einzelsubstrats und des zweiten Einzelsubstrats diese entsprechend der vorgenannten Bedingung eine unterschiedliche Größe aufweisen müssen. Wenn hingegen das erste Einzelsubstrat und das zweite Einzelsubstrat dieselbe Form, zum Beispiel rechteckig, und dieselbe Größe, das heißt identische Außenabmessungen, aufweisen, muss eines der beiden Einzelsubstrate gegenüber dem anderen gedreht sein, bevorzugt um +/- 90 Grad, um die vorgenannte Bedingung zu erfüllen. In beiden Fällen ist es somit möglich, den wie eingangs beschrieben bei Mehrfachsubstraten nach dem Stand der Technik ansonsten verlorenen Substratbereich durch Drehen des zweiten Einzelsubstrats und/oder durch Verkleinern des zweiten Einzelsubstrats ebenso für die Fertigung von Einzelsubstraten zu nutzen. Hierdurch wird insgesamt eine effektivere Nutzung der von dem Mehrfachsubstrat zur Verfügung gestellten Substratfläche möglich, wodurch sich insbesondere auch die Herstellungskosten der Einzelsubstrate reduzieren lassen, da sich pro Mehrfachsubstrat mehr Einzelsubstrate im Vergleich zum Stand der Technik fertigen lassen.

Eine vorteilhafte Ausgestaltung der Erfindung sieht vor, dass das erste Einzelsubstrat und das zweite Einzelsubstrat bezüglich ihrer Außenabmessungen gleich groß ausgebildet sind, das zweite Einzelsubstrat jedoch gegenüber dem ersten Einzelsubstrat um +/- 90 Grad gedreht ist. Somit lassen sich mehr Einzelsubstrate derselben Größe und Form, vorzugsweise rechteckig, auf der zur Verfügung stehenden Substratfläche des Mehrfachsubstrats anordnen als es bei einer matrixförmigen, gleichorientierten Anordnung aller Einzelsubstrate der Fall ist.

Eine alternative vorteilhafte Ausgestaltung der Erfindung sieht vor, dass das erste Einzelsubstrat und das zweite Einzelsubstrat bezüglich ihrer Außenabmessungen unterschiedlich groß ausgebildet sind. Auch hierdurch lassen sich mehr Einzelsubstrate auf der zur Verfügung stehenden Substratfläche des Mehrfachsubstrats anordnen als es bei einer matrixförmigen, gleichorientierten Anordnung gleich großer Einzelsubstrate möglich ist.

Gemäß einer noch weiteren vorteilhaften Ausgestaltung der Erfindung sind zwischen dem ersten Einzelsubstrat und dem zweiten Einzelsubstrat zwei Schnittlinien verlaufend angeordnet, die einen gleichmäßigen Abstand von wenigstens 2 mm, vorzugsweise 4 mm, zueinander aufweisen. Hierdurch werden T-förmig aneinandergrenzende Schnittlinien zwischen dem ersten Einzelsubstrat und dem zweiten Einzelsubstrat vermieden, da diese beim Schneiden entlang der Schnittlinien während des Vereinzelns der Einzelsubstrate zu Einkerbungen an der jeweiligen T-förmigen Berührungsstelle führen kann. Derartige Einkerbungen am Einzelsubstrat können dessen mechanische Stabilität unvorteilhafterweise verringern.

Eine noch weitere vorteilhafte Ausgestaltung der Erfindung sieht vor, dass wenigstens eine optisch erkennbare Passermarke auf dem ersten Einzelsubstrat und/oder zweiten Einzelsubstrat vorgesehen ist. Hierbei kann die Passermarke sowohl auf der Vorderseite als auch auf der Rückseite des Einzelsubstrats angeordnet sein. Die Anordnung der Passermarke auf dem Einzelsubstrats ermöglicht die vollständige Nutzung der gesamten von dem Mehrfachsubstrat bereitgestellten Substratfläche durch die Einzelsubstrate. Die Passermarke dient bei allen Bearbeitungsschritten des Mehrfachsubstrats dazu, dieses für den jeweiligen Bearbeitungsschritt, zum Beispiel Aufbringen einer Metallisierung, beispielsweise Kupfer, auf die Einzelsubstrate, Strukturieren der Metallisierung in Leiterbahnen und Kontaktflächen etc., Bestücken der Einzelsubstrate mit elektronischen Bauelementen und dergleichen, richtig auszurichten.

Bevorzugt ist die wenigstens eine Passermarke als eine Durchätzung der auf die Einzelsubstrate aufgebrachten Metallisierung, zum Beispiel Kupfer, ausgebildet, beispielsweise als kreisrunde Durchätzung. Weiterhin bevorzugt ist die Durchätzung zur besseren optischen Erkennung von mindestens 1 mm der Metallisierung umgeben.

Gemäß einer weiteren vorteilhaften Ausgestaltung der Erfindung umfasst das erste Einzelsubstrat mehrere bezüglich seiner Außenabmessungen gleich große, gleichorientiert und zusammenhängend angeordnete erste Einzelsubstrate. Ebenso umfasst das zweite Einzelsubstrat in dieser Ausgestaltung mehrere bezüglich seiner Außenabmessungen gleich große, gleichorientiert und zusammenhängend angeordnete zweite Einzelsubstrate.

Mit anderen Worten sind sowohl mehrere erste Einzelsubstrate als auch mehrere zweite Einzelsubstrate jeweils matrixartig, das heißt jeweils gleich groß und gleichorientiert, auf dem Mehrfachsubstrat angeordnet. Hierbei sind die zweiten Einzelsubstrate wie vorstehend beschrieben gegenüber den ersten Einzelsubstraten anders ausgebildet und/oder anders auf dem Mehrfachsubstrat ausgerichtet, um die von dem Mehrfachsubstrat zur Verfügung gestellte Substratfläche effizienter, im besten Falle vollständig, zu nutzen. Des Weiteren lassen sich die beiden Teilbereiche des Mehrfachsubstrats, in denen sich entweder die mehreren ersten Einzelsubstrate oder die mehreren zweiten Einzelsubstrate befinden, in einem späteren Verarbeitungsschritt voneinander trennen, zum Beispiel durch Laserschneiden und/oder Brechen entlang der die ersten Einzelsubstraten von den zweiten Einzelsubstraten abgrenzenden Schnittlinie, und getrennt voneinander, jedoch jeweils noch zusammenhängend, weiterverarbeiten, um die Effizienz bei der Fertigung der Einzelsubstrate noch weiter zu steigern.

Eine noch weitere vorteilhafte Ausgestaltung der Erfindung sieht vor, dass neben dem ersten Einzelsubstrat und dem zweiten Einzelsubstrat wenigstens ein weiteres Einzelsubstrat vorgesehen ist, wobei wenigstens eine längste Ausdehnung des ersten Einzelsubstrats entlang einer der beiden Erstreckungsrichtungen von einer längsten Ausdehnung des zweiten Einzelsubstrats entlang derselben Erstreckungsrichtung und von einer längsten Ausdehnung des weiteren Einzelsubstrats entlang derselben Erstreckungsrichtung verschieden ist.

Bevorzugt umfasst das wenigstens eine weitere Einzelsubstrat mehrere bezüglich seiner Außenabmessungen gleich große, gleichorientiert und zusammenhängend angeordnete weitere Einzelsubstrate.

In dieser Ausgestaltung können auf dem Mehrfachsubstrat dementsprechend drei unterschiedliche Gruppen von Einzelsubtraten, nämlich erste, zweite und dritte, angeordnet sein, die sich jeweils in ihrer Größe und/oder Ausrichtung auf dem Mehrfachsubstrat unterscheiden, um die von dem Mehrfachsubstrat zur Verfügung gestellte Substratfläche noch effektiver zu nutzen.

Des Weiteren lassen sich die drei Teilbereiche des Mehrfachsubstrats, in denen sich entweder die mehreren ersten Einzelsubstrate, die mehreren zweiten Einzelsubstrate oder die mehreren weiteren (dritten) Einzelsubstrate befinden, in einem späteren Verarbeitungsschritt voneinander trennen, zum Beispiel durch Laserschneiden und/oder Brechen entlang der die ersten von den zweiten und weiteren (dritten) Einzelsubstraten begrenzenden Schnittlinien, und getrennt voneinander, jedoch jeweils noch zusammenhängend, weiterverarbeiten, um die Effizienz bei der Fertigung der Einzelsubstraten noch weiter zu steigern.

Weitere Merkmale und Vorteile der Erfindung ergeben sich aus der folgenden Beschreibung nicht einschränkend zu verstehender Ausführungsbeispiele der Erfindung, die im Folgenden unter Bezugnahme auf die Zeichnung näher erläutert werden. In dieser Zeichnung zeigen schematisch:
- Fig. 1: eine Draufsicht auf ein Mehrfachsubstrat nach dem Stand der Technik,
- Fig. 2: eine Draufsicht auf ein erstes Ausführungsbeispiel eines Mehrfachsubstrats gemäß der Erfindung,
- Fig. 3: eine Draufsicht auf ein zweites Ausführungsbeispiel eines Mehrfachsubstrats gemäß der Erfindung,
- Fig. 4: eine Draufsicht auf ein drittes Ausführungsbeispiel eines Mehrfachsubstrats gemäß der Erfindung und
- Fig.5: eine Draufsicht auf ein viertes Ausführungsbeispiel eines Mehrfachsubstrats gemäß der Erfindung.

In den unterschiedlichen Figuren sind hinsichtlich ihrer Funktion gleichwertige Teile stets mit denselben Bezugszeichen versehen, so dass diese in der Regel auch nur einmal beschrieben werden.

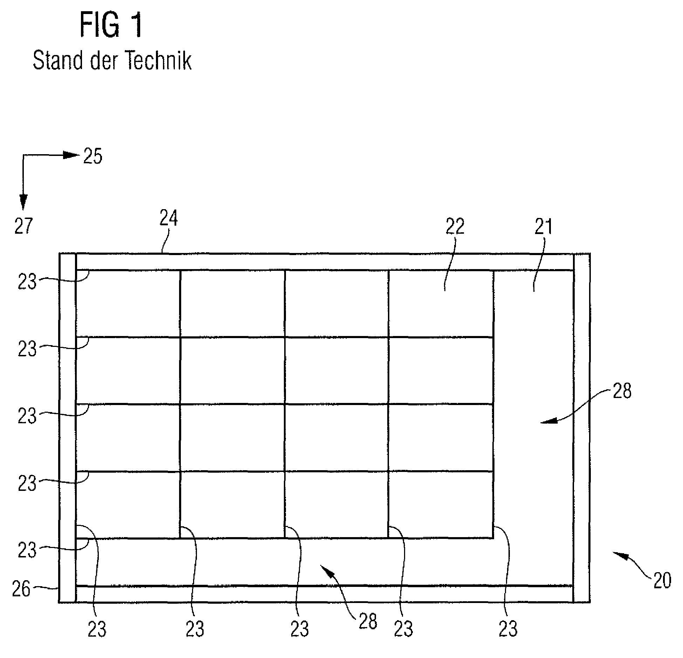

Fig. 1 stellt eine Draufsicht auf ein rechteckiges Mehrfachsubstrat 20 nach dem Stand der Technik dar. Das Mehrfachsubstrat 20 umfasst eine Keramikplatte oder Keramikschicht 21, die bei dem gezeigten Beispiel mehrere aneinander anschließende und einstückig miteinander verbundene Einzelsubstrate 22 bildet. Die Einzelsubstrate 22 sind jeweils durch zwischen diesen verlaufende Schnittlinien 23 voneinander abgegrenzt.

Des Weiteren erstreckt sich ein erster Rand 24 der Keramikschicht 21 entlang einer ersten Erstreckungsrichtung 25 des Mehrfachsubstrats 20 und ein zweiter Rand 26 der Keramikschicht 21 erstreckt sich entlang einer zweiten Erstreckungsrichtung 27 des Mehrfachsubstrats 20. Bei dem in Fig. 1 gezeigten Beispiel des Mehrfachsubstrats 20 verläuft die erste Erstreckungsrichtung 25 senkrecht zur zweiten Erstreckungsrichtung 27 und das Mehrfachsubstrat 20 ist rechteckig ausgebildet.

Wie in Fig. 1 zu erkennen ist, sind auf dem Mehrfachsubstrat 20 insgesamt 16, in ihren Außenabmessungen gleich große Einzelsubstrate 22 zusammenhängend matrixartig angeordnet, die jeweils von fünf in Fig. 1 vertikal verlaufenden und fünf horizontal verlaufenden Schnittlinien 23 begrenzt sind. Zur Vereinzelung der Einzelsubstrate 22 wird das Mehrfachsubstrat 20 in an sich bekannter Weise entlang der Schnittlinien 23 vorzugsweise mittels eines Lasers geschnitten und/oder gebrochen.

Des Weiteren ist in Fig. 1 ein Bereich 28 des Mehrfachsubstrats 20 zu erkennen, in dem aufgrund seiner verbleibenden Größe keine weiteren ganzen Einzelsubstrate 22 mehr in derselben Größe und Orientierung wie jene der 16 bereits vorhandenen Einzelsubstrate 22 angeordnet werden können. Dieser Verlustbereich 28 geht für die Fertigung der Einzelsubstrate 22 auf dem Mehrfachsubstrat 20 verloren.

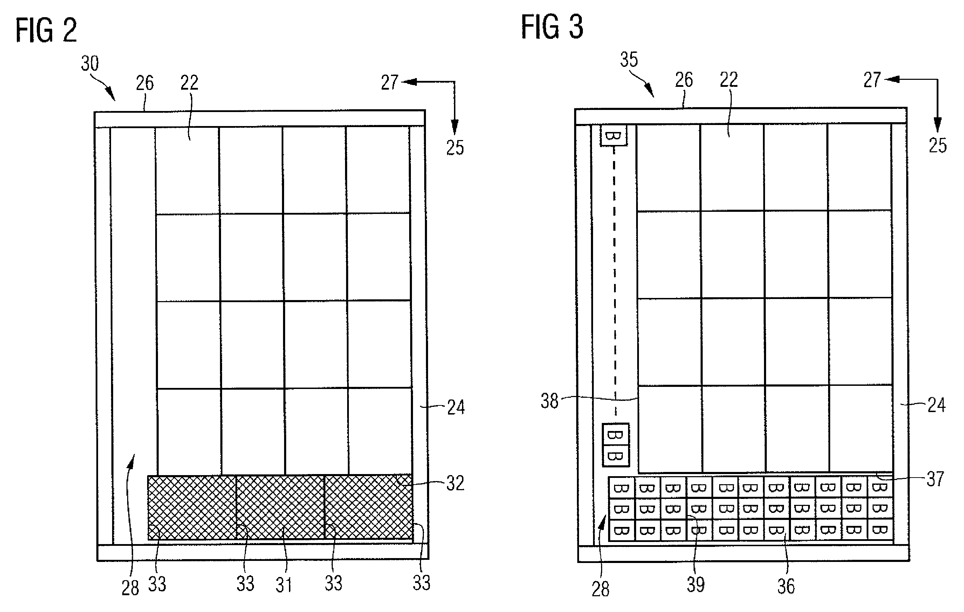

Fig. 2 stellt eine Draufsicht auf ein erstes Ausführungsbeispiel eines erfindungsgemäßen Mehrfachsubstrats 30 dar. Bei einem Vergleich des in Fig. 2 dargestellten erfindungsgemäßen Mehrfachsubstrats 30 mit dem in Fig. 1 dargestellten herkömmlichen Mehrfachsubstrat 20 ist zu erkennen, dass auf der Substratfläche des Mehrfachsubstrats 30 neben den 16 ersten rechteckigen Einzelsubstraten 22 noch drei weitere, zweite rechteckige Einzelsubstrate 31 angeordnet sind. Bei dem in Fig. 2 gezeigten Ausführungsbeispiel des Mehrfachsubstrats 30 sind diese zweiten Einzelsubstrate 31 zwar bezüglich ihrer Außenabmessungen gleich groß wie die ersten Einzelsubstraten 22 ausgebildet, jedoch gegenüber diesen um +/- 90 Grad gedreht auf der Substratfläche, insbesondere in dem in Fig. 1 gezeigten großflächigen Verlustbereich 28, angeordnet, wodurch der Verlustbereich 28 bei dem in Fig. 2 gezeigten Mehrfachsubstrat 30 erheblich kleiner ist als bei dem Mehrfachsubstrat 20 nach dem Stand der Technik (Fig. 1). Die Drehung der zweiten Einzelsubstrate 31 ergibt, dass sowohl die längste Ausdehnung eines ersten Einzelsubstrats 22 entlang der ersten Erstreckungsrichtung 25 des Mehrfachsubstrats 30 als auch die längste Ausdehnung desselben Einzelsubstrats 22 entlang der zweiten Erstreckungsrichtung 27 des Mehrfachsubstrats 30 von der entsprechenden längsten Ausdehnung eines zweiten Einzelsubstrats 31 entlang der jeweiligen selben Erstreckungsrichtung 25 bzw. 27 verschieden sind.

Wie weiter in Fig. 2 zu erkennen ist, sind die ersten Einzelsubstrate 22 von den zweiten Einzelsubstraten 31 durch eine Schnittlinie 32 abgegrenzt. Somit lässt sich das Mehrfachsubstrat 30 entlang dieser Schnittlinie 32 auch in jeweils einen ersten Teilbereich des Mehrfachsubstrats 30, der lediglich die ersten Einzelsubstrate 22 zusammenhängend umfasst, und in einen zweiten Teilbereich, der lediglich die zweiten Einzelsubstrate 31 zusammenhängend umfasst, entlang dieser Schnittlinie 32 trennen. Die beiden Teilbereiche lassen sich somit in späteren Verarbeitungsschritten getrennt voneinander, jedoch weiterhin jeweils zusammenhängend, weiterverarbeiten.

Die zweiten Einzelsubstrate 31 sind zur Ermöglich der Vereinzelung ebenfalls durch weitere Schnittlinien 33 untereinander abgegrenzt.

Fig. 3 stellt eine Draufsicht auf ein zweites Ausführungsbeispiel eines erfindungsgemäßen Mehrfachsubstrats 35 dar. Bei diesem Ausführungsbeispiel sind neben den ersten Einzelsubstraten 22 auch mehrere zweite Einzelsubstrate 36 auf der Substratfläche des Mehrfachsubstrats 35 angeordnet, wobei die zweiten Einzelsubstrate 36 gegenüber den ersten Einzelsubstraten 22 bezüglich ihrer Außenabmessungen unterschiedlich groß, insbesondere kleiner, ausgebildet sind. Außerdem sind die zweiten Einzelsubstrate 36 hinsichtlich ihrer rechteckigen Ausgestaltung gegenüber den ersten Einzelsubstraten 22 um +/- 90 Grad gedreht, wodurch auch bei diesem Ausführungsbeispiel der Verlustbereich 28 bei dem in Fig. 3 gezeigten Mehrfachsubstrat 35 erheblich kleiner ist als bei dem Mehrfachsubstrat 20 nach dem Stand der Technik (Fig. 1). Die unterschiedliche Größe der zweiten Einzelsubstrate 36 ergibt, dass sowohl die längste Ausdehnung eines ersten Einzelsubstrats 22 entlang der ersten Erstreckungsrichtung 25 des Mehrfachsubstrats 35 als auch die längste Ausdehnung desselben Einzelsubstrats 22 entlang der zweiten Erstreckungsrichtung 27 des Mehrfachsubstrats 35 von der entsprechenden längsten Ausdehnung eines zweiten Einzelsubstrats 36 entlang der jeweiligen selben Erstreckungsrichtung 25 bzw. 27 verschieden sind.

Auch in dem in Fig. 3 dargestellten Ausführungsbeispiel des Mehrfachsubstrats 35 sind die zweiten Einzelsubstrate 36 von den ersten Einzelsubstraten 22 durch eine Schnittlinie 37 bzw. 38 abgegrenzt, so dass der Teilbereich des Mehrfachsubstrats 35, der lediglich die ersten Einzelsubstrate 22 umfasst, von einem Teilbereich des Mehrfachsubstrats 35, der lediglich die zweiten Einzelsubstrate 36 umfasst, getrennt werden kann, wie vorstehend am Beispiel des Mehrfachsubstrats 30 (Fig. 2) bereits beschrieben wurde. Außerdem sind selbstverständlich auch weitere, die jeweiligen zweiten Einzelsubstrate 36 voneinander abgrenzende Schnittlinien 39 zur Vereinzelung der zweiten Einzelsubstrate 36 vorgesehen, wie in Fig. 3 zu sehen ist.

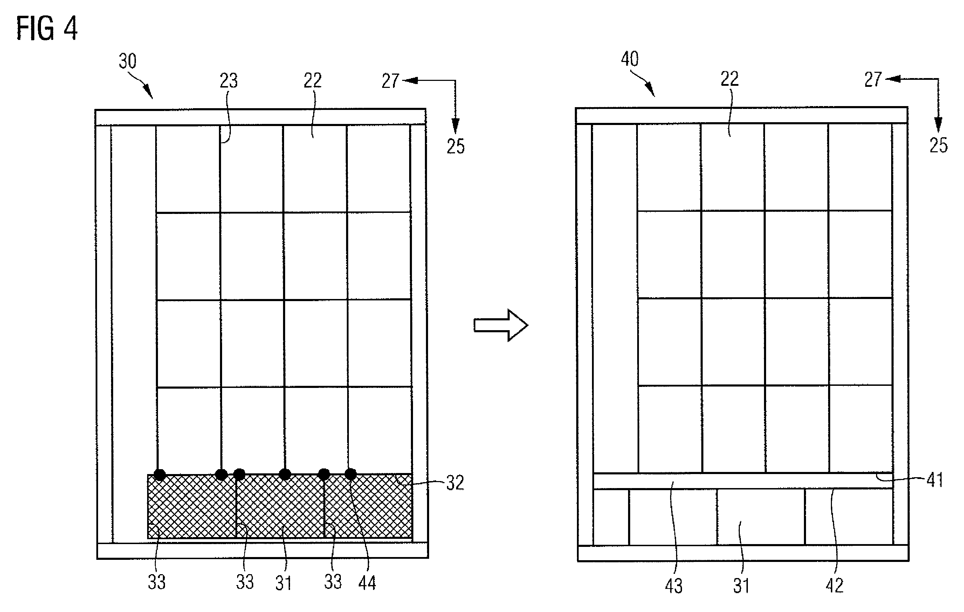

Fig. 4 stellt in einer rechten bzw. oberen Bildhälfte eine Draufsicht auf ein drittes Ausführungsbeispiel eines Mehrfachsubstrats 40 gemäß der Erfindung dar, wohingegen in einer linken bzw. unteren Bildhälfte erneut eine Draufsicht auf das Mehrfachsubstrat 30 aus Fig. 2 dargestellt ist. Wie in Fig. 4 zu erkennen ist, sind zwischen den ersten Einzelsubstraten 22 und den zweiten Einzeisubstraten 31 zwei Schnittlinien 41 und 42 verlaufend angeordnet, die einen gleichmäßigen Abstand von vorzugsweise mehr als 2 mm, zum Beispiel 4 mm, voneinander aufweisen. Hierdurch wird zwischen den ersten Einzelsubstraten 22, die an die Schnittlinie 41 angrenzen, und den zweiten Einzelsubstraten 31, die an die Schnittlinie 42 angrenzen, ein unbelegter Substratstreifen 43 gebildet. Dieser verhindert, dass bei dem Mehrfachsubstrat 30, wie in der linken bzw. unteren Bildhälfte der Fig. 4 angedeutet ist, an den T-förmigen Berührungsstellen der Schnittlinien 23, 32 und 33 beim Schneiden und/oder Brechen des Mehrfachsubstrats 30 Einkerbungen oder Ausbrüche 44 in den Einzelsubstraten 22 bzw. 31 entstehen. Diese würden zu einer unvorteilhaft verringerten mechanischen Stabilität der entsprechenden Einzelsubstrate 22 bzw. 31 führen, was durch die Anordnung des unbelegten Substratstreifens 43 zwischen die ersten Einzelsubstrate 22 und die zweiten Einzelsubstrate 31 vermieden wird.

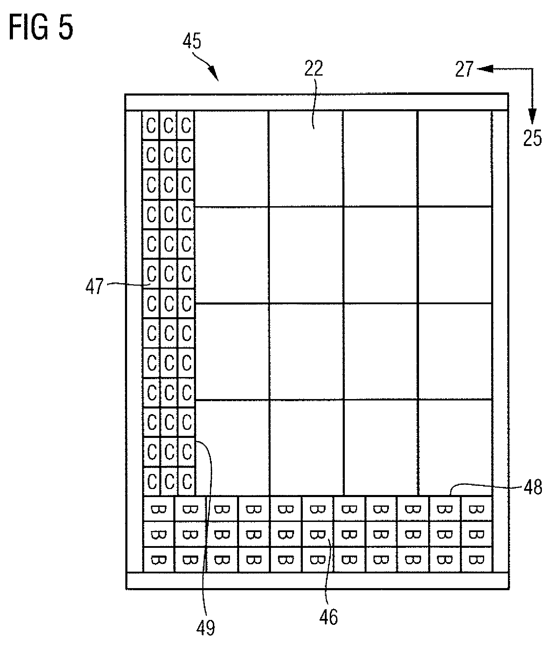

Fig. 5 stellt eine Draufsicht auf ein viertes Ausführungsbeispiel eines erfindungsgemäßen Mehrfachsubstrats 45 dar. Wie in Fig. 5 zu erkennen ist, ist im Wesentlichen die gesamte von dem Mehrfachsubstrat 45 zur Verfügung gestellte Substratfläche durch mehrere erste, zweite und weitere (dritte) Einzelsubstrate 22, 46 und 47 belegt und damit die von dem Mehrfachsubstrat 45 zur Verfügung gestellte Substratfläche vollständig und optimal genutzt. Fig. 5 ist zu entnehmen, dass die zweiten Einzelsubstrate 46 in ihren Außenabmessungen unterschiedlich, insbesondere kleiner, ausgebildet sind als die ersten Einzelsubstrate 22. Des Weiteren sind auch die weiteren (dritten) Einzelsubstrate 47 in ihren Außenabmessungen unterschiedlich, insbesondere kleiner, ausgebildet als die ersten Einzelsubstrate 22 und auch in ihren Außenabmessungen unterschiedlich, insbesondere nochmals kleiner, als die zweiten Einzelsubstrate 46 ausgebildet. Somit umfasst das Mehrfachsubstrat 45 insgesamt drei unterschiedliche Typen von Einzelsubstraten 22, 46 und 47.

Wie bereits zuvor beschrieben wurde, sind auch bei diesem Ausführungsbeispiel des Mehrfachsubstrats 45 die Teilbereiche der Substratfläche, die lediglich jeweils die mehreren ersten Einzelsubstrate 22, die mehreren zweiten Einzelsubstrate 46 bzw. die mehreren weiteren (dritten) Einzelsubstrate 47 umfassen, voneinander durch entsprechende Schnittlinien 48 und 49 abgegrenzt. Somit lassen sich diese Teilbereiche voneinander trennen und dann in einem nachfolgenden Bearbeitungsschritt getrennt voneinander weiterverarbeiten, wobei die ersten, zweiten und weiteren (dritten) Einzelsubstrate auf dem jeweiligen Substratteilbereich zusammenhängend bleiben können, wodurch die Fertigung aller Einzelsubstrate 22, 46, 47 effizienter durchgeführt werden kann.

Die vorstehend beschriebenen erfindungsgemäßen Mehrfachsubstrate sind nicht auf die hierin offenbarten Ausführungsformen beschränkt, sondern umfassen auch gleich wirkende weitere Ausführungsformen. Insbesondere können auch noch mehr als die in den Ausführungsbeispielen beschriebenen zwei oder drei unterschiedlich angeordnete und/oder in der Größe verschiedene Arten von Einzelsubstraten auf dem Mehrfachsubstrat angeordnet sein.

In bevorzugter Ausführung wird das erfindungsgemäße Mehrfachsubstrat, insbesondere Mehrfach-Keramiksubstrat, mit einer auf wenigstens einer Oberflächenseite des Keramiksubstrats aufgebrachten Metallisierung, zum Beispiel Kupfer oder Aluminium, zur Herstellung von elektrischen Schaltkreisen, insbesondere Leistungsschaltkreisen, verwendet.

### Bezugszeichenliste:

- 20: Mehrfachsubstrat nach dem Stand der Technik
- 21: Keramikplatte oder Keramikschicht
- 22: Einzelsubstrat
- 23: Schnittlinie
- 24: Erster Rand von 21
- 25: Erste Erstreckungsrichtung
- 26: Zweiter Rand von 21
- 27: Zweite Erstreckungsrichtung
- 28: Verlustbereich
- 30: Mehrfachsubstrat
- 31: Einzelsubstrats
- 32: Schnittlinie
- 33: Schnittlinie
- 35: Mehrfachsubstrat
- 36: Einzelsubstrat
- 37: Schnittlinie
- 38: Schnittlinie
- 39: Schnittlinie
- 40: Mehrfachsubstrat
- 41: Schnittlinie
- 42: Schnittlinie
- 43: Unbelegter Substratstreifen
- 44: Einkerbung
- 45: Mehrfachsubstrat
- 46: Einzelsubstrat
- 47: Einzelsubstrat
- 48: Schnittlinie
- 49: Schnittlinie

## Patentansprüche

1. Mehrfachsubstrat mit einer Keramikplatte oder Keramikschicht (21), die wenigstens zwei aneinander anschließende und einstückig miteinander verbundene Einzelsubstrate (22, 31, 36, 46, 47) bildet, die durch wenigstens eine zwischen den Einzelsubstraten (22, 31, 36, 46, 47) verlaufende Schnittlinie (32, 37, 41, 42, 48, 49) voneinander abgegrenzt sind, wobei sich ein erster Rand (24) der Keramikschicht (21) entlang einer ersten Erstreckungsrichtung (25) erstreckt und sich ein zweiter Rand (26) der Keramikschicht (21) entlang einer zweiten Erstreckungsrichtung (27) erstreckt,
**dadurch gekennzeichnet, dass**
wenigstens eine längste Ausdehnung des ersten Einzelsubstrats (22) entlang einer der beiden Erstreckungsrichtungen (25, 27) von einer längsten Ausdehnung des zweiten Einzelsubstrats (31, 36, 46, 47) entlang derselben Erstreckungsrichtung (25, 27) verschieden ist.

2. Mehrfachsubstrat nach Anspruch 1,
**dadurch gekennzeichnet, dass**
das erste Einzelsubstrat (22) und das zweite Einzelsubstrat (31) bezüglich ihrer Außenabmessungen gleich groß ausgebildet sind, das zweite Einzelsubstrat (31) jedoch gegenüber dem ersten Einzelsubstrat () um +/-90 Grad gedreht ist.

3. Mehrfachsubstrat nach Anspruch 1,
**dadurch gekennzeichnet, dass**
das erste Einzelsubstrat (22) und das zweite Einzelsubstrat (36, 46, 47) bezüglich ihrer Außenabmessungen unterschiedlich groß ausgebildet sind.

4. Mehrfachsubstrat nach einem der vorhergehenden Ansprüche,
**dadurch gekennzeichnet, dass**
das zwischen dem ersten Einzelsubstrat (22) und dem zweiten Einzelsubstrat (31, 36, 46, 47) zwei Schnittlinien (41, 42) verlaufend angeordnet sind, die einen gleichmäßigen Abstand von wenigstens 2 mm, vorzugsweise 4 mm, zueinander aufweisen.

5. Mehrfachsubstrat nach einem der vorhergehenden Ansprüche,
**dadurch gekennzeichnet, dass**
wenigstens eine optisch erkennbare Passermarke auf dem ersten Einzelsubstrat (22) und/oder zweiten Einzelsubstrat (31, 36, 46, 47) vorgesehen ist.

6. Mehrfachsubstrat nach einem der vorhergehenden Ansprüche,
**dadurch gekennzeichnet, dass**
das erste Einzelsubstrat (22) mehrere bezüglich seiner Außenabmessungen gleich große, gleichorientiert und zusammenhängend angeordnete erste Einzelsubstrate umfasst und das zweite Einzelsubstrat (31, 36, 46, 47) mehrere bezüglich seiner Außenabmessungen gleich große, gleichorientiert und zusammenhängend angeordnete zweite Einzelsubstrate umfasst.

7. Mehrfachsubstrat nach einem der vorhergehenden Ansprüche,
**dadurch gekennzeichnet, dass**
neben dem ersten Einzelsubstrat (22) und dem zweiten Einzelsubstrat (31, 36, 46) wenigstens ein weiteres Einzelsubstrat (47) vorgesehen ist, wobei wenigstens eine längste Ausdehnung des ersten Einzelsubstrats (22) entlang einer der beiden Erstreckungsrichtungen (25, 27) von einer längsten Ausdehnung des zweiten Einzelsubstrats (31, 36, 46) entlang derselben Erstreckungsrichtung (25, 27) und von einer längsten Ausdehnung des weiteren Einzelsubstrats (47) entlang derselben Erstreckungsrichtung (25, 27) verschieden ist.

8. Mehrfachsubstrat nach dem vorhergehenden Anspruch,
**dadurch gekennzeichnet, dass**
das weitere Einzelsubstrat (47) mehrere bezüglich seiner Außenabmessungen gleich große, gleichorientiert und zusammenhängend angeordnete weitere Einzelsubstrate umfasst.
